# EUROPEAN PATENT APPLICATION

(11) **EP 4 730 381 A1**
(43) Date of publication of application: **22.04.2026**
(21) Application number: 24306766.7
(22) Date of filing: 21.10.2024
(51) Int. Cl.: H01G 4/33, H01G 4/005, H10D 1/68, H01L 23/535, H01G 4/38, H01G 4/40, C25D 11/04, H01G 4/01

(54) **AN INTEGRATED STRUCTURE WITH AN ANODIZATION BARRIER LAYER FORMED ON A PROTECTIVE LINER, AND CORRESPONDING METHOD**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: VOIRON, Frédéric, 14000 CAEN (FR); SOULIER, Brigitte, 14000 CAEN (FR); SALLAZ, Valentin, 14000 CAEN (FR); LAVIRON, Cyrille, 38054 Grenoble cedex 09 (FR); FERREIRA, Delphine, 38054 Grenoble cedex 09 (FR); BAUDIN, Floriane, 38054 Grenoble cedex 09 (FR); DOMINGUEZ, Sébastien, 38054 Grenoble cedex 09 (FR)
(74) Representative: Cabinet Beau de Loménie

(57) **Abstract**

An integrated structure comprising:
a substrate (100, 101),
a conductive layer, the conductive layer having a first cavity, the first cavity (102C) being filled with a first insulating region (103F), the first insulating region having a top surface flush with a top surface of the conductive layer to form a first planar surface (F1),
a protective liner (104) on the top surface of the conductive layer and the top surface of the first insulating region,
an anodization barrier layer (105) on the protective liner,
the protective liner and the anodization barrier layer having a second cavity (105_104C) passing through the protective liner and the anodization barrier layer and opening onto the first insulating region, the second cavity being filled with a second insulating region (106F), the second insulating region having a top surface flush with a top surface of the anodization barrier layer to form a second planar surface (F2).

## Description

### Field of the Invention

The present invention relates to the field of integration and, more particularly, to electrical devices including porous regions and their methods of manufactures.

### Technical Background

Silicon passive integration technologies are nowadays accessible for industrial design. For example, the PICS technology developed by Murata Integrated Passive Solutions allows integrating high density capacitive components into a silicon substrate. According to this technology, tens or even hundreds of passive components can be efficiently integrated into a silicon die.

In their work entitled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron *et al.* that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive anodization barrier layer that underlies the porous region, providing electrical contact and reducing ESR.

Generally, PAA embedded structures as described above result from embedding a structure (e.g., a MIM capacitive stack) inside a porous region above a substrate, such as a silicon wafer. Typically, the porous region results from anodizing a thin layer of metal, such as aluminum, deposited above the substrate. The anodization converts the aluminum layer into porous anodic alumina. The porous region can be formed with any shape (as viewed from the top) when a mask is used, and extends across the alumina layer in a direction perpendicular to the wafer surface. Alternatively, no mask is used and the entire aluminum layer is anodized.

As explained above, the aluminum layer (or a layer containing another anodizable metal) is usually formed above layer of metal that forms an anodization barrier (for example containing tungsten). The barrier is used to prevent anodization of the underlying substrate (if it contains anodizable material), the anodization process creates an oxide of the material of the barrier layer at the bottom ends of the pores, which may subsequently prevent the anodization fluid and the pores from progressing into the underlying substrate.

Under the metal barrier, and in the topmost region of the substrate, a conductive layer (for example comprising aluminum) is formed. This layer acts as an electrical collector for the bottom electrode of a subsequently formed capacitor that will extend at the bottom of pores of the porous anodic alumina.

In order to disconnect the bottom electrode of separate capacitors formed above a same substrate, it is necessary to pattern the metal barrier layer and the underlying conductive layer.

Document EP 4389942 discloses how metal barrier layers present an uneven surface because of their polycrystalline nature. This document proposes planarizing the metal barrier layers prior to depositing the material to be anodized.

It has been observed that this process remains unsatisfactory as some devices appear to be defective.

The present invention has been made in the light of the above problems.

### Summary of the Invention

The invention provides an integrated structure comprising:
a substrate (for example but not necessarily a substrate having an insulating region at the level of its top surface),
a conductive layer on the substrate, the conductive layer having a first cavity opening onto the substrate, the first cavity being filled with a first insulating region, the first insulating region having a top surface flush with a top surface of the conductive layer to form a first planar surface,
a protective liner (preferably electrically conductive) on the top surface of the conductive layer and the top surface of the first insulating region,
an anodization barrier layer on the protective liner,
the protective liner and the anodization barrier layer having a second cavity passing through the protective liner and the anodization barrier layer and opening onto the first insulating region, the second cavity being filled with a second insulating region, the second insulating region having a top surface flush with a top surface of the anodization barrier layer to form a second planar surface.

It is in this manufacturing context that the inventors of the present invention have observed that in devices according to the prior art lacking a protective liner, planarizing an anodization barrier layer along with the insulating regions leads to the presence of cracks and/or holes in the anodization barrier layer, which then lead to defective devices as the bottom electrode of subsequently formed capacitors can interact with the conductive layer through the cracks/holes and corrode.

The presence of cracks/holes has been observed by the inventors to be a consequence of the thermal budget seen by the conductive layer during the subsequent formation of the anodization barrier. The conductive layer is usually planarized through a CMP process which makes its surface unstable. Consequently, even low to moderate thermal budget (i.e. above 50°C) lead to hillocks forming on the top surface of the conductive layer. Those hillocks can have a height of several hundred nanometres that may not be completely passivated by the anodization barrier layer. In fact, using a low temperature (to limit hillocks from growing) also leads to a poor conformality when depositing the anodization barrier layer. Furthermore, planarizing the anodization barrier layer tends to reveal the hillocks that are embedded within the anodization barrier layer, and these exposed hillocks may lead to defects by interacting with subsequently formed layers (for example MIM stacks).

In other words, the inventors have observed that the temperatures required to form the anodization layer on the conductive layer lead to the underlying conductive layer (often comprising a polycrystalline metal in an unstable state after having been planarized) to reach a level of roughness. The anodization barrier layer, which is usually thin (100nm to 500nm), when planarized over the uneven conductive layer, can be locally teared off above a salient grain of metal which forms a hole or a crack.

By using a suitably selected protective liner, it is possible to cap the conductive layer, for example after a CMP step preventing the formation of hillocks during the deposition of the anodization barrier layer. Facilitating forming the anodization barrier layer can include having a protective liner with a very low thickness (typ. Sub 120nm, preferably 30nm) preferably of a reactive metal (like Ti or Ti/TiN bilayer), having a good adhesion to the conductive layer and a good adhesion to the anodization metal barrier, even at low deposition temperatures.

Various protective liners can be used.

Here and for example, it should be noted that by planar surface, what is meant is a surface having a roughness Rmax of less than 50nm and/or a roughness RMS of less than 5nm. Such surface roughness values can be measured by means of an AFM.

According to a particular embodiment, the protective liner comprises a conductive material adhering to the conductive layer and allowing deposition of the material of the anodization metal barrier layer at a temperature below 50°C or preferably below 30°C, for example the protective liner comprises TiTiN, for example having a thickness below 120nm, or preferably below 50nm, or preferably below 30nm.

By "adhering to the conductive layer and allowing deposition of the material of the anodization metal barrier", what is meant is that no delamination is observed when a subsequent deposition is performed on the anodization metal barrier, for example a layer of material to be anodized (typically aluminum).

TiTiN can be deposited on the conductive layer (typically comprising aluminium) at low temperatures (for example below 50°C or even 30°C). This prevents the conductive layer from retrieving its surface roughness. TiTiN also allows depositing the anodization barrier layer (typically comprising tungsten) also at low temperatures (for example below 50°C or even 30°C) with a suitable adhesion.

According to a particular embodiment, the device further comprises a porous region (for example an anodic porous oxide region) on the second planar surface, the porous region comprising a plurality of substantially straight pores that extend from a top surface of the porous region towards the bottom of the porous region, the pores opening onto the second planar surface.

For example, the porous region can be obtained by anodizing a layer of anodizable metal such as aluminium, and be referred to as an anodic porous oxide region. Alternatively, only a portion of anodizable metal can be anodized, if a hard mask is used to delimit a portion to be anodized.

According to a particular embodiment, the first insulating region forms a ring surrounding a central portion of the conductive layer, and wherein the second insulating region forms a ring surrounding a central portion of the protective liner and a central portion of the anodization barrier layer.

The first and second insulating region forming a ring means that when observed from the top they are shaped as a ring.

In this particular embodiment, the central portion of the anodization barrier can accommodate a component such as a MIM capacitor, which will be laterally electrically insulated from other components formed on the other side of the ring-shaped first and second insulating regions. Document EP3680931 discloses this lateral electrical insulation.

According to a particular embodiment, a group of pores of the porous region located above the central portion of the anodization barrier layer include a stack of layers including a bottom electrode layer, an intermediate layer (for example a dielectric layer if the stack of layers forms a capacitor, included in each pore of the group of pores), and a top electrode layer, the stack of layers extending conformally on sidewalls and on the bottom of the pores of the group of pores of the porous region,
and wherein another group of pores surrounding the group of pores and located above a portion of the anodization barrier layer surrounding the central portion of the anodization barrier layer remain empty or filled with an insulating material.

By conformally, what is meant is that the bottom electrode layer follows the contours defined by the pores, the intermediate layer follows the contours defined by the pores filled with the bottom electrode layer, and the top electrode layer follows the contours defined by the pores filled with the bottom electrode layer and the intermediate layer.

In this embodiment, the another group of pores is ring-shaped, for example. Also, by remaining empty or filled with an insulating material, a lateral insulating region is obtained.

According to a particular embodiment, pores of a group of pores of the porous region located above the central portion of the anodization barrier layer include conductive wires (each pore comprises a conductive wire, a conductive being formed by filling at least partially a pore from the bottom of the pore to the top of the pore) in contact at the bottom of the pores with the anodization barrier layer and connected together at the top of the pores, the conductive wires forming a vertical via.

The invention is not limited to integrated structures comprising capacitors, and also applies to other types of devices, for example vertical conductive vias arranged in porous regions.

The invention also provides a method of manufacturing an integrated structure comprising:
providing a substrate and a conductive layer arranged on the substrate,
forming a first cavity in the conductive layer opening onto the substrate,
filling the first cavity with a first insulating region, and forming a first planar surface including a top surface of the first insulating region flush with a top surface of the conductive layer,
forming a protective liner on the top surface of the conductive layer and the top surface of the first insulating region,
forming an anodization barrier layer on the protective liner,
forming a second cavity passing through the protective liner and the anodization barrier layer and opening onto the first insulating region,
filling the second cavity a second insulating region, and forming a second planar surface including a top surface of the second insulating region flush with a top surface of the anodization barrier layer.

This method can be adapted to obtain any embodiment of the above defined integrated structure.

According to a particular embodiment, the protective liner comprises a conductive material adhering to the conductive layer and allowing deposition of the material of the anodization metal barrier layer at a temperature below 50°C or preferably below 30°C, for example the protective liner comprises TiTiN.

According to a particular embodiment, forming the first planar surface comprises filling the first cavity and covering an initial top surface of the conductive layer with an insulating material, and performing a planarization to obtain the first planar surface including a top surface of the first insulating region flush with a top surface of the conductive layer.

By way of example, the planarization can include a chemical mechanical polishing (CMP) configured to remove the excess insulating material until reaching the conductive layer. For example, the CMP can use a slurry selective with respect to the material of the conductive layer. Also, the planarization can include a surface levelling step, for example a second CMP with an unselective slurry.

According to a particular embodiment, forming the second planar surface comprises filling the second cavity and covering an initial top surface of the anodization barrier layer with an insulating material, and performing a planarization to obtain the first planar surface including a top surface of the first insulating region flush with a top surface of the conductive layer.

By way of example, the planarization can include a chemical mechanical polishing (CMP) configured to remove the excess insulating material until reaching the anodization barrier layer. For example, the CMP can use a slurry selective with respect to the material of the anodization barrier layer. Also, the planarization can include a surface levelling step, for example a second CMP with an unselective slurry.

According to a particular embodiment, the method further comprises forming a region of anodizable material on the second planar surface.

According to a particular embodiment, the method comprises anodizing the region of anodizable material to obtain a porous region on the second planar surface, the porous region comprising a plurality of substantially straight pores that extend from a top surface of the porous region towards the bottom of the porous region, the pores opening onto the second planar surface.

According to a particular embodiment, the first insulating region forms a ring surrounding a central portion of the conductive layer, and wherein the second insulating region forms a ring surrounding a central portion of the protective liner and a central portion of the anodization barrier layer.

According to a particular embodiment, a group of pores of the porous region located above the central portion of the anodization barrier layer include a stack of layers including a bottom electrode layer, an intermediate layer, and a top electrode layer, the stack of layers extending conformally on sidewalls and on the bottom of the pores of the group of pores of the porous region,
and wherein another group of pores surrounding the group of pores and located above a portion of the anodization barrier layer surrounding the central portion of the anodization barrier layer remain empty or filled with an insulating material.

According to a particular embodiment, the method comprises forming, within pores of a group of pores of the porous region located above the central portion of the anodization barrier layer, conductive wires in contact at the bottom of the pores with the anodization barrier layer and connected together at the top of the pores, the conductive wires forming a vertical via.

### Brief Description of the Drawings

Further features and advantages of the present invention will become apparent from the following description of certain embodiments thereof, given by way of illustration only, not limitation, with reference to the accompanying drawings in which:
- Figure 1A is a high resolution SEM image showing a conductive layer retrieving its roughness.
- Figure 1B is a SEM image showing cracks appearing in an anodization barrier layer.
- Figure 2A is another high resolution SEM image showing a conductive layer retrieving its roughness.
- Figure 2B is a SEM image showing a hole appearing in an anodization barrier layer.
- Figure 3 is a schematic representation of a substrate with a conductive layer.
- Figure 4 shows a cavity and an insulating layer formed on the structure of figure 3.
- Figure 5 shows the structure of figure 4 after a planarizing.
- Figure 6 shows the structure of figure 5 with a protective liner and an anodization barrier layer.
- Figure 7 shows the structure of figure 6 after a planarizing.
- Figure 8 shows the structure of figure 7 with an anodizable metal layer.
- Figure 9 shows the structure of figure 8 after an anodization.
- Figure 10 shows the structure of figure 9 after components have been formed inside the pores.

### Detailed Description of Example Embodiments

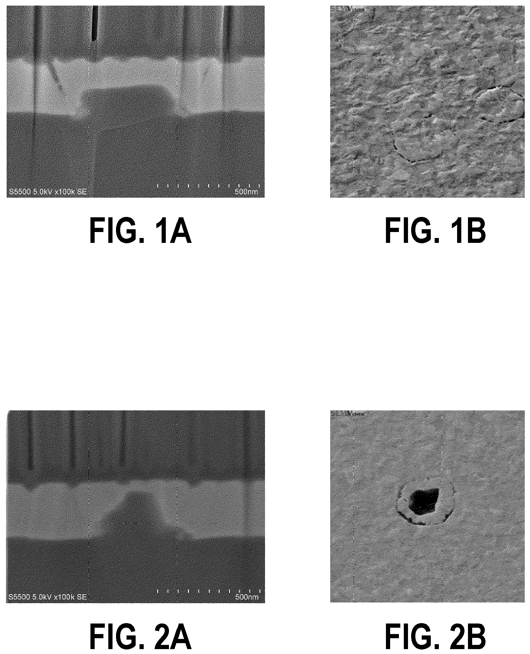

The inventors of the present invention have observed that conductive layers such as aluminium layers configured to act as collectors under anodization metal barrier often retrieve their roughness when the anodization metal barrier is deposited. This prevents the obtained structures from being suitable to receive porous structures in which the pores are filled with stacks of layers such as capacitors. Figure 1A shows such a structure in which a grain from an underlying aluminium layer is salient through an anodization barrier layer comprising tungsten. When planarized, the structure of figure 1A can be the structure of figure 1B wherein a crack is visible.

Figure 2A shows another irregular interface between aluminium and an anodization barrier layer. Figure 2B shows how a hole is formed as the thin anodization barrier layer above a grain is easily teared off.

We will now describe the steps to manufacture an integrated structure suitable to accommodate an anodizable metal layer, on a planar surface. The following examples overcome the issues visible on figures 1A to 2B.

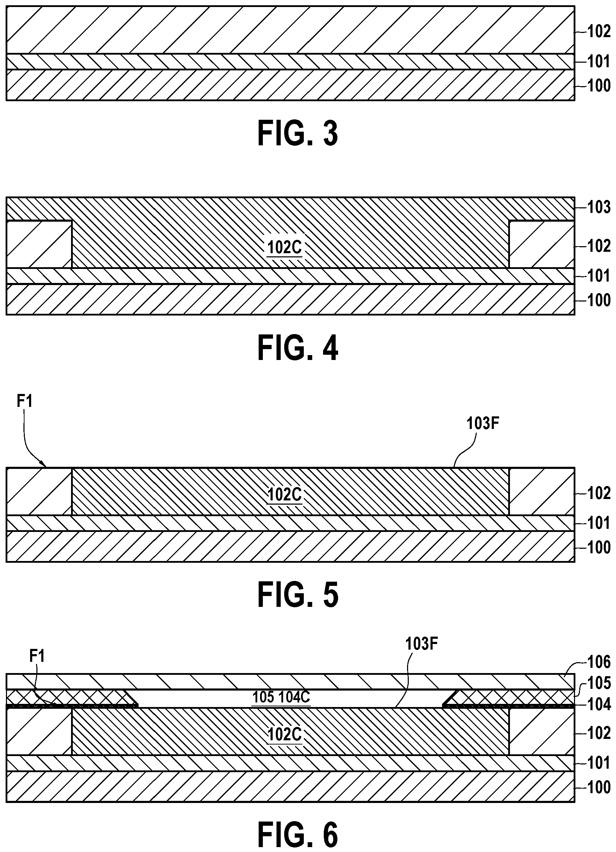

Figure 3 shows a base structure comprising a support substrate 100, for example a glass or silicon support substrate, on top of which an oxide layer 101 has been grown or deposited. Oxide layer 101 will participate to electrically insulating components such as capacitors formed subsequently above this base structure.

Above oxide layer 101, a conductive layer 102, for example a metal layer has been formed. Conductive layer 102 can comprise a metal, for example aluminium or copper. It should be noted if copper is used, TiTiN may have to be deposited under and around the copper to avoid potential contamination.

As shown on figure 4, a first cavity 102C is formed in the conductive layer 102. While not visible on the figure, this cavity can be ring-shaped. For example, it surrounds when observed from the top on the figure the right side portion of the conductive layer which remains on the side of the cavity. The right side portion of the conductive layer is electrically disconnected from the left side portion of the conductive layer, as they are formed on oxide layer 101.

The cavity first 102C opens onto the underlying layer oxide layer 101 (the oxide layer 101 and the support substrate 100 form a substrate including both the oxide layer 101 and the support substrate 100, and the cavity then opens onto this substrate).

The first cavity 102C has been filled by an insulating layer 103 deposited so as to completely fill the cavity and so as to cover conductive layer 102. For example, insulating layer 103 can comprise tetraethoxysilane (TEOS).

Figure 5 shows the structure of figure 4 after a planarizing step has been performed. As can be observed on the figure, the first cavity 102C is filled with a first insulating region 103F (resulting from the initial insulating layer 103), and the top surface of the first insulating region 103 is flush with the top surface of the conductive layer 102 to form a first planar surface F1.

Planarizing the structure of figure 4 can include a CMP using a selective slurry configured to stop when the conductive layer is reached (a gross levelling is performed). Another CMP can be implemented with a non-selective slurry to obtain a planar surface (local roughness is removed).

It should be noted that the conductive layer can have its thickness reduced during the planarizing (i.e. its top surface moves downwards on the figure).

Figure 6 shows the structure of figure 5 after a protective liner 104 has been deposited. In this example, the protective liner comprises TiTiN. In an intermediary step not shown on the figure, the protective liner 104 entirely covers the first planar surface F1. Also, above the protective liner 104, an anodization barrier layer 105 has been deposited. For example, the anodization barrier layer comprises tungsten. Protective liner can have a thickness comprises between 30 nm and 120 nm.

Both the protective liner and the anodization barrier layer can be deposited under temperatures of less than 50°C or even less than 30°C, with an appropriate selection of material for the protective liner.

A second cavity 105_104C has been formed through both the protective liner 104 and the anodization barrier layer 105.

The second cavity 105_104C opens onto only the first insulating region 103F. Here, the second cavity 105_104C has a perimeter which is entirely comprised within the perimeter of the first cavity 102C when observed from the top. Consequently, the second cavity does not open onto the conductive layer 102.

It should be noted that the second cavity 105_104C is represented on the figures as having slanted edges. The slanted edges facilitate filling the second cavity and avoids the presence of voids.

The invention is not limited to slanted edges and can also be implemented with vertical edges.

The second cavity 105_104C has been filled with an insulating layer 106, for example the same or a material which differs from insulating layer 102 described above. For example, insulating layer 106 can comprise tetraethoxysilane (TEOS).

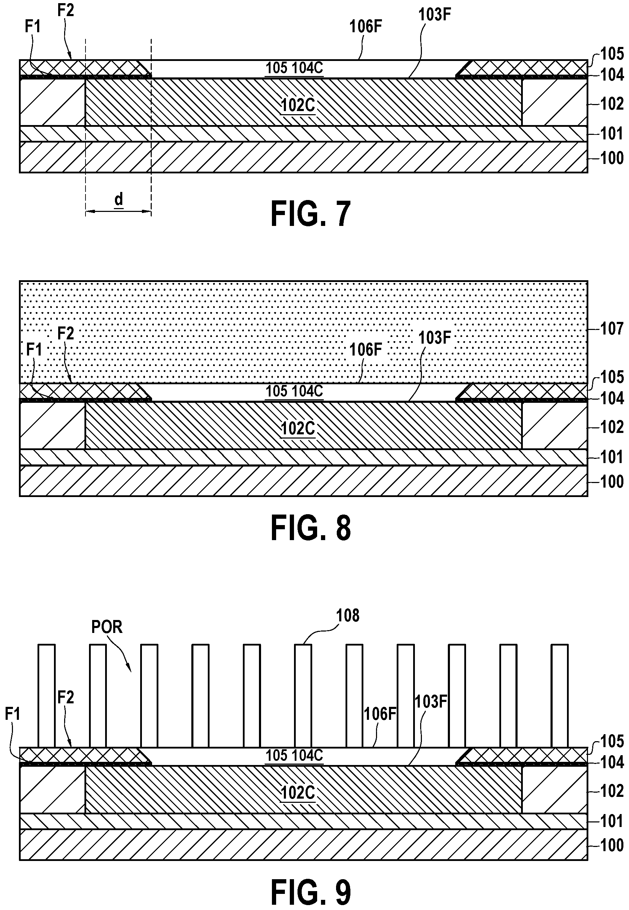

Figure 7 shows the structure of figure 6 after a planarizing step has been performed. As can be observed on the figure, the second cavity 105_104C is filled with a second insulating region 106F (resulting from the initial insulating layer 106), and the top surface of the second insulating region 106 is flush with the top surface of the anodization barrier layer 105 to form a second planar surface F2.

Planarizing the structure of figure 6 can include a CMP using a selective slurry configured to stop when the anodization barrier layer is reached. Another CMP can be implemented with a non-selective slurry to obtain a planar surface.

It should be noted that the anodization barrier layer can have its thickness reduced during the planarizing (i.e. its top surface moves downwards on the figure).

At this stage, an integrated structure suitable to receive a layer of anodizable material is obtained. This integrated structure presents a top planar surface with a low level of surface roughness, for example a surface a roughness Rmax of less than 50nm and/or a roughness RMS of less than 5nm.

Distance d visible on the figure measured between the edge of first cavity 102C and the edge of the second cavity 105_104C can be set in accordance with the limits of the photolithographic process.

Figure 8 shows the structure of figure 7 after an anodizable metal layer 107 has been deposited on the second planar surface 107. By way of example, the anodizable metal layer 107 can have a thickness of the order of tens of micrometres. Also, for example, anodizable metal layer comprises aluminium.

Figure 9 shows the structure of figure 8 after an anodization step. Pores POR have been formed in an anodic porous oxide region (the invention also applies to other types of porous regions), each pore POR extending between the top surface of the anodic porous oxide region and the second planar surface F2 (the pores open onto this planar surface). If necessary, an intermediate step can be implemented wherein an oxide plug is removed at the bottom of all or a portion of the pores (typically an oxide plug comprising an oxide of the material of the anodization barrier layer). By opening onto, what is meant is that the pore is defined by substantially cylindrical walls of anodic porous oxide opening onto the second planar surface, regardless of the presence of another oxide at the bottom of the pores.

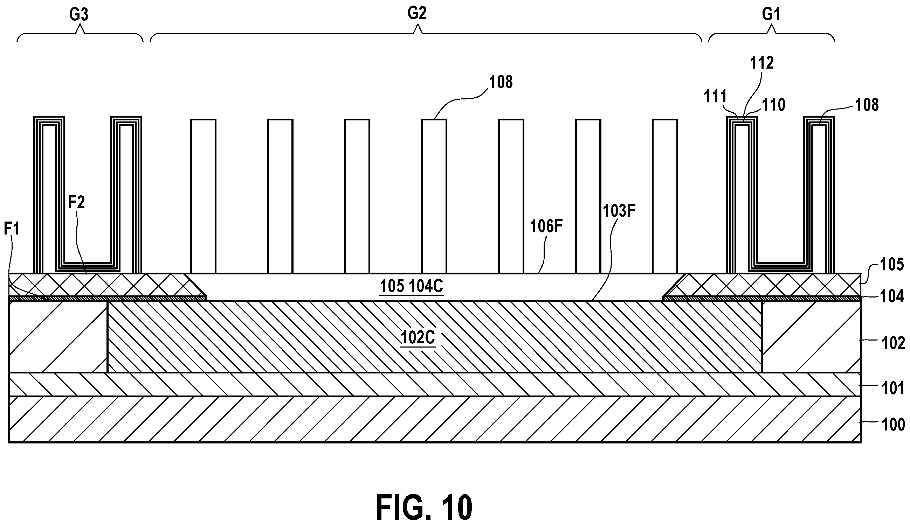

Figure 10 shows the structure of figure 9 with additional layers. In particular, and as shown on figure 10, three groups of pores G1, G2 and G3 are defined.

Group G1 corresponds to a group of pores selected to accommodate a capacitor with a bottom electrode layer 110 deposited conformally on the walls and at the bottom of the pores of group G1, a dielectric layer 111 deposited conformally on the bottom electrode layer, and a top electrode layer 112 deposited conformally on the dielectric layer 111.

The bottom electrode layer is electrically connected at the bottom of pores to the anodization barrier layer. The anodization barrier layer is electrically connected to the protective liner (here a conductive layer), and consequently to the conductive layer 102 (the right portion on the figure). The conductive layer 102 acts as a collector here. While not shown on the figure, an electrical connection between conductive layer 102 and the top surface can be implemented.

The anodic porous oxide and the pores of group G2, formed above the first and second insulating regions 103F and 106F and above oxide layer 101 electrically insulate the capacitor formed with group G1.

Here, another capacitor has been formed in the pores of group G3, with no electrical connection between the capacitor of group G3 and the capacitor of group G1.

The above method and structure allows obtaining devices including anodic porous oxide with a low level of failures as the protective liner facilitates depositing an anodization barrier layer while maintaining a low surface roughness.

In the above method, filling the two cavities is performed using two processes that can be called "Damascene" as they include overfilling a cavity and performing a planarizing to obtain a planar surface.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An integrated structure comprising:
a substrate (100, 101),
a conductive layer on the substrate, the conductive layer having a first cavity opening onto the substrate, the first cavity (102C) being filled with a first insulating region (103F), the first insulating region having a top surface flush with a top surface of the conductive layer to form a first planar surface (F1),
a protective liner (104) on the top surface of the conductive layer and the top surface of the first insulating region,
an anodization barrier layer (105) on the protective liner,
the protective liner and the anodization barrier layer having a second cavity (105_104C) passing through the protective liner and the anodization barrier layer and opening onto the first insulating region, the second cavity being filled with a second insulating region (106F), the second insulating region having a top surface flush with a top surface of the anodization barrier layer to form a second planar surface (F2).

2. The integrated structure of claim 1, wherein the protective liner comprises a conductive material adhering to the conductive layer and allowing deposition of the material of the anodization metal barrier layer at a temperature below 50°C or preferably below 30°C, for example the protective liner comprises TiTiN, for example having a thickness below 120nm, or preferably below 50nm, or preferably below 30nm.

3. The integrated structure of claim 1 or 2, further comprising a porous region (108) on the second planar surface, the porous region comprising a plurality of substantially straight pores (POR) that extend from a top surface of the porous region towards the bottom of the porous region, the pores opening onto the second planar surface.

4. The integrated structure of any one of claims 1 to 3, wherein the first insulating region forms a ring surrounding a central portion of the conductive layer, and wherein the second insulating region forms a ring surrounding a central portion of the protective liner and a central portion of the anodization barrier layer.

5. The integrated structure of claims 3 and 4, wherein a group of pores (G1) of the porous region located above the central portion of the anodization barrier layer include a stack of layers including a bottom electrode layer, an intermediate layer, and a top electrode layer, the stack of layers extending conformally on sidewalls and on the bottom of the pores of the group of pores of the porous region,
and wherein another group of pores (G2) surrounding the group of pores and located above a portion of the anodization barrier layer surrounding the central portion of the anodization barrier layer remain empty or filled with an insulating material.

6. The integrated structure of claims 3 and 4, wherein pores of a group of pores of the porous region located above the central portion of the anodization barrier layer include conductive wires in contact at the bottom of the pores with the anodization barrier layer and connected together at the top of the pores, the conductive wires forming a vertical via.

7. A method of manufacturing an integrated structure comprising:
providing a substrate (100, 101) and a conductive layer arranged on the substrate,
forming a first cavity (102C) in the conductive layer opening onto the substrate,
filling the first cavity with a first insulating region (103F), and forming a first planar surface (F1) including a top surface of the first insulating region flush with a top surface of the conductive layer,
forming a protective liner (104) on the top surface of the conductive layer and the top surface of the first insulating region,
forming an anodization barrier layer (105) on the protective liner,
forming a second cavity (105_104C) passing through the protective liner and the anodization barrier layer and opening onto the first insulating region,
filling the second cavity (106F) with a second insulating region, and forming a second planar surface including a top surface of the second insulating region flush with a top surface of the anodization barrier layer (F2).

8. The method of claim 7, wherein the protective liner comprises a conductive material adhering to the conductive layer and allowing deposition of the material of the anodization metal barrier layer at a temperature below 50°C or preferably below 30°C, for example the protective liner comprises TiTiN.

9. The method of claim 7 or 8, wherein forming the first planar surface comprises filling the first cavity and covering an initial top surface of the conductive layer with an insulating material (103), and performing a planarization to obtain the first planar surface including a top surface of the first insulating region flush with a top surface of the conductive layer.

10. The method of any one of claims 7 to 9, wherein forming the second planar surface comprises filling the second cavity and covering an initial top surface of the anodization barrier layer with an insulating material (106), and performing a planarization to obtain the first planar surface including a top surface of the first insulating region flush with a top surface of the conductive layer.

11. The method of any one of claims 7 to 10, further comprising forming a region of anodizable material (107) on the second planar surface.

12. The method of claim 11, comprising anodizing the region of anodizable material to obtain a porous region (108) on the second planar surface, the porous region comprising a plurality of substantially straight pores (POR) that extend from a top surface of the oxide region towards the bottom of the porous region, the pores opening onto the second planar surface.

13. The method of any one of claims 7 to 12, wherein the first insulating region forms a ring surrounding a central portion of the conductive layer, and wherein the second insulating region forms a ring surrounding a central portion of the protective liner and a central portion of the anodization barrier layer.

14. The method of claims 12 and 13, wherein a group of pores (G1) of the porous region located above the central portion of the anodization barrier layer include a stack of layers including a bottom electrode layer, an intermediate layer, and a top electrode layer, the stack of layers extending conformally on sidewalls and on the bottom of the pores of the group of pores of the porous region,
and wherein another group of pores (G2) surrounding the group of pores and located above a portion of the anodization barrier layer surrounding the central portion of the anodization barrier layer remain empty or filled with an insulating material.

15. The method of claims 12 and 13, comprising forming, within pores of a group of pores of the porous region located above the central portion of the anodization barrier layer, conductive wires in contact at the bottom of the pores with the anodization barrier layer and connected together at the top of the pores, the conductive wires forming a vertical via.
